(19) Europäisches Patentamt / European Patent Office / Office européen des brevets

(11) **EP 2 743 444 A1**

(12) **EUROPEAN PATENT APPLICATION**

(43) Date of publication:
**18.06.2014 Bulletin 2014/25**

(51) Int Cl.:
*E21B 33/14* (2006.01)          *C09K 8/467* (2006.01)
*E21B 43/24* (2006.01)

(21) Application number: **12306603.7**

(22) Date of filing: **17.12.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
• **Services Pétroliers Schlumberger**
  **75007 Paris (FR)**
  Designated Contracting States:
  **AL FR RS**
• **Schlumberger Holdings Limited**
  **Tortola (VG)**
  Designated Contracting States:
  **AL GB NL RS**
• **Prad Research Development Limited**
  **Tortola (VG)**
  Designated Contracting States:
  **AL AT BE CH CY EE ES FI HR IS LI LU LV MC MK MT PT RS SE SM**
• **Schlumberger Technology B.V.**
  **2514 JG The Hague (NL)**
  Designated Contracting States:
  **AL BG CZ DE DK GR HU IE IT LT NO PL RO RS SI SK TR**

(72) Inventors:
• **James, Simon**
  **92142 Clamart Cedex (FR)**
• **Chougnet-Sirapian, Alice**
  **92142 Clamart Cedex (FR)**

(74) Representative: **Vandermolen, Mathieu**
  **Etudes & Productions Schlumberger**
  **IP Department**
  **1, rue Henri Becquerel**
  **B.P. 202**
  **92142 Clamart (FR)**

(54) **Compositions and methods for well completions**

(57)    Thermal recovery wells, geothermal wells and deep hot wells may involve the application of heat to the cement sheath and well casing at some time after the cement has set. Such heating may subject the cement sheath to mechanical burdens that may lead to failure. Such burdens may be lessened if the linear thermal coefficient of expansion is variable and approximates that of the well casing. A variable linear thermal coefficient of expansion may be achieved by incorporating blast furnace slag, silica fume, fly ash or a combination thereof in the cement blend.

Figure 2

**Description**

**BACKGROUND OF THE INVENTION**

The statements in this section merely provide background information related to the present disclosure and may not constitute prior art.

This invention relates to compositions and methods for treating subterranean formations, in particular, compositions and methods for cementing and completing thermal recovery wells.

During the construction of subterranean wells, it is common, during and after drilling, to place a tubular body in the wellbore. The tubular body may comprise drillpipe, casing, liner, coiled tubing or combinations thereof. The purpose of the tubular body is to act as a conduit through which desirable fluids from the well may travel and be collected. The tubular body is normally secured in the well by a cement sheath. The cement sheath provides mechanical support and hydraulic isolation between the zones or layers that the well penetrates. The latter function is important because it prevents hydraulic communication between zones that may result in contamination. For example, the cement sheath blocks fluids from oil or gas zones from entering the water table and polluting drinking water. In addition, to optimize a well's production efficiency, it may be desirable to isolate, for example, a gas-producing zone from an oil-producing zone.

The cement sheath achieves hydraulic isolation because of its low permeability. In addition, intimate bonding between the cement sheath and both the tubular body and borehole is necessary to prevent leaks. However, over time the cement sheath can deteriorate and become permeable. Alternatively, the bonding between the cement sheath and the tubular body or borehole may become compromised. The principal causes of deterioration and debonding include physical stresses associated with tectonic movements, temperature changes and chemical deterioration of the cement.

When oil and gas wells are subjected to temperature changes (e.g., during steam injection or the production of hot reservoir fluids), the casing expands and induces stresses in the cement sheath. Development of heavy oil reserves often involves applying heat to the producing reservoir. Such thermal-recovery wells frequently employ steam injection. Steam injection encompasses a number of techniques, including steam assisted gravity drainage (SAGD), cyclic steam stimulation (CSS) and steamflooding. During such operations, the resulting well temperature may vary from 150° to 350°C, subjecting the cement sheath to especially severe stresses and possibly leading to cement-sheath failure, formation of microannuli or both. Indeed, a significant percentage of thermal-recovery wells suffer from various forms of leaks including complete steam breakthrough to surface.

The effects of heating on the cement sheath are complex; however, numerical simulations may be performed to assess the processes. It can generally be observed that cement sheaths with higher linear thermal expansion coefficients (LCTEs) experience less strain when the casing expands. Therefore, having cement systems with LCTEs close to or higher than that of the casing may be advantageous.

Furthermore, it may be observed that the strain imparted to the cement sheath increases with the heating rate in the well. At high heating rates the cement sheath temperature may be much lower than that of the casing, increasing the strain in the cement sheath at short times. Over a longer period, as the cement-sheath and casing temperatures equilibrate, the cement-sheath strain decreases. At a wellsite it is often difficult to adjust the heating rate. Therefore, again, it would be advantageous to have cement systems with higher LCTEs to minimize cement-sheath strain during the heat-up phase.

**SUMMARY**

Embodiments allow improvements by providing cement formulations whose thermal-expansion properties may be optimized for a particular well environment.

In an aspect, embodiments relate to methods for designing a cement system having a borehole penetrating subterranean formations, at least one casing string and at least one cement sheath. A candidate cement system is selected such that the cement sheath has a known Young's modulus, Poisson's ratio, tensile strength and a variable linear thermal expansion coefficient. The cement system further contains a material that reduces the permeability of the cement sheath. The well and casing geometries are determined. A computer simulator is then used to determine cement-sheath integrity and tangential stress upon the application of heat, pressure or both in the well. If the simulation indicates cement-sheath failure, the candidate cement system is modified such that the variable thermal expansion coefficient is adjusted, and the computer simulator is used again to determine cement-sheath integrity and tangential stress. If the simulation indicates no failure, the candidate cement system is then selected as a final design.

In a further aspect, embodiments relate to methods for cementing a subterranean well having a borehole, at least one casing string and at least one cement sheath. A candidate cement system is selected such that the cement sheath has a known Young's modulus, Poisson's ratio, tensile strength and a variable thermal expansion coefficient. The cement is a Portland cement and the cement system further comprises blast furnace slag, silica fume, fly ash or a combination thereof. The well and casing geometries are determined. A computer simulator is then used to determine cement-sheath integrity and tangential stress upon the application of heat, pressure or both in the well. If the simulation indicates cement-sheath failure, the candidate cement system is modified such that the variable thermal expansion coefficient is adjusted, and the computer simulator is used again to determine cement-sheath integrity and tangential stress. If the simulation indicates no failure, the candidate cement system is then selected as a final design. A cement slurry is prepared according to the final design and is then placed in the well. The slurry is allowed to set and then the well is heated.

**BRIEF DESCRIPTION OF THE DRAWINGS**

Figure 1 is a graph that shows how the heat-up rate in a well affects the tangential stress of a cement sheath at the cement-casing interface.

Figure 2 is a graph that illustrates the variable LCTE of a cement sheath according to the disclosure.

Figure 3 is graph showing how the cement-sheath LCTE affects the tangential stress at the cement-casing interface.

Figure 4 is a graph showing the temperature cycles in an apparatus for measuring the LCTE of a cement sample.

Figure 5 is a graph showing the deformation of a cement sample cured at 30°C during the temperature cycles.

Figure 6 is a graph showing the calculated LCTEs determined from the temperature cycles and deformations illustrated in Figs. 4 and 5.

Figure 7 is a graph showing the deformation of a cement sample cured at 85°C during the temperature cycles.

Figure 8 is a graph showing the heat-up profiles for cement samples during thermal expansion measurements.

Figure 9 is a graph showing the thermal expansion of cement samples heated at 25°C/hr.

Figure 10 is a graph showing the thermal expansion of cement samples heated at 10°C/hr.

Figure 11 is a graph comparing the thermal expansion behavior of cement samples containing silica fume, fly ash, blast furnace slag or metakaolin.

**DETAILED DESCRIPTION**

The invention may be described in terms of treatment of vertical wells, but is equally applicable to wells of any orientation. The invention may be described for hydrocarbon production wells, but it is to be understood that the invention may be used for wells for production of other fluids, such as water or carbon dioxide, or, for example, for injection or storage wells. It should also be understood that throughout this specification, when a concentration or amount range is described as being useful, or suitable, or the like, it is intended that any and every concentration or amount within the range, including the end points, is to be considered as having been stated. Furthermore, each numerical value should be read once as modified by the term "about" (unless already expressly so modified) and then read again as not to be so modified unless otherwise stated in context. For example, "a range of from 1 to 10" is to be read as indicating each and every possible number along the continuum between about 1 and about 10. In other words, when a certain range is expressed, even if only a few specific data points are explicitly identified or referred to within the range, or even when no data points are referred to within the range, it is to be understood that the inventors appreciate and understand that any and all data points within the range are to be considered to have been specified, and that the inventors have possession of the entire range and all points within the range.

Most materials expand when they are heated; without wishing to be bound by any theory, it is believed that as the temperature increases, the distance between the atoms also increases. Thermal expansion may be expressed in various ways. The linear coefficient of thermal expansion (LCTE) describes the specific linear elongation of a material per unit value of temperature and at a constant pressure. The areal coefficient of thermal expansion (ACTE) relates the change in a material's area dimensions as a function of temperature. The volumetric coefficient of thermal expansion (VCTE) describes the change in volume of a material per unit value of temperature. For exactly isotropic materials, the VCTE is three times the LCTE.

A typical LCTE for a conventional set Portland cement is about $8 \cdot 10^{-6}/°C$, whereas the typical LCTE for carbon steel is about $13 \cdot 10^{-6}/°C$. Thus, when a cement sheath around casing is subjected to a thermal load, the dimensions of the casing will change more than those of a conventional Portland-cement sheath. In the presence of thermal loads associated with thermal-recovery wells, geothermal wells and deep-hot wells, the dimensional divergence may induce significant mechanical stresses on the cement sheath, leading to cement-sheath failure in either tensile or compressive modes, or both. A typical thermal-recovery well involves the application of steam. In geothermal wells, heating occurs upon the initiation of well production, when steam or hot brine travels uphole toward the surface. Similarly, in deep-hot wells, heating occurs uphole upon the production of hot oil and gas from deep formations.

The present disclosure concerns methods to minimize the aforementioned stresses by providing set cements whose LCTEs are more compatible with the casing LCTE. It would be advantageous to have cement systems whose LCTEs are close to or higher than that of carbon steel casing.

A modeling application, such as CemSTRESS™ cement sheath stress analysis software, available from Schlumberger, can be employed to analyze a well completion and a proposed well-production strategy, and aid cement-slurry design. The physics of the model is described in the following publication: Thiercelin MJ et al.: "Cement Design Based on Cement Mechanical Response," paper SPE 52890 (1998). The software may be used to determine the optimal mechanical properties of the set cement and the necessary amount of cement-sheath expansion. Ultimately, a cement system may be designed that meets the requirements specified by the software.

CemSTRESS™ simulations may help determining the effect of the heating rate in a well upon the integrity of the cement sheath. Without wishing to be bound by any theory, it is believed that as the heating rate increases, the mechanical burden experienced by the cement sheath also increases. Owing to differential heat capacity and thermal conductivity, the casing temperature will increase more quickly than the cement sheath, increasing the strain and the tangential stress at the cement-formation interface. Eventually, as the well temperature equilibrates, the stress and strain become less severe.

These concepts may be illustrated by considering the wellbore situation described in Table 1.

Table 1. Input parameters for cement-sheath failure simulations.

| | | **Rock** | |
|---|---|---|---|
| Open Hole | 21.6 cm (8.5 in.) | Young's Modulus | 7000 MPa |
| Casing (carbon steel) | 17.8 cm (7.0 in.), 38 kg/m | Poisson's Ratio | 0.3 |
| Standoff | 100% | LCTE | $13 \times 10^{-6}/°C$ |
| | | **Cement** | |
| | | Unconfined Compressive Strength | 48 MPa |
| | | Tensile Strength | 4.8 MPa |
| | | Young's Modulus | 8500 MPa |
| Temperature Ramp | 21°C to 121°C at various rates | Poissons Ratio | 0.15 |

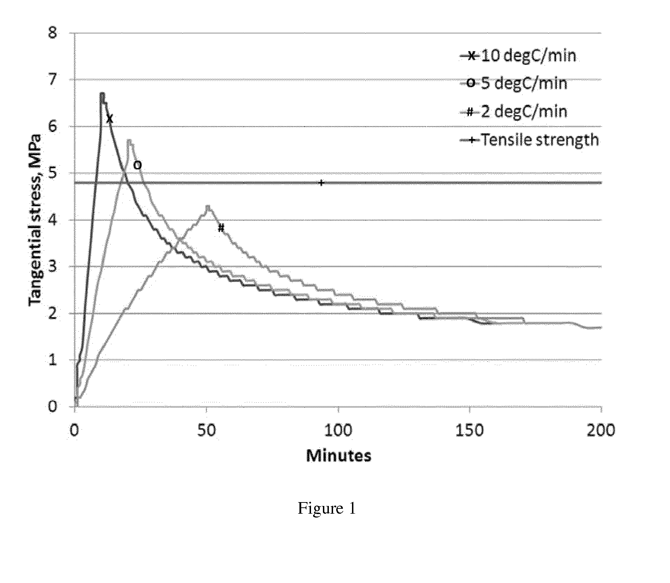

A first CemSTRESS™ simulation investigated the effect of the heat-up rate on the tangential stress generated in the cement at the casing-cement interface. Heating rates varied from 2°C/min to 10°C/min. The results, shown in Fig. 1, show that the tangential stress increased with heat-up rate. In all cases, there was a tangential stress peak, after which the stress falls as the well temperature equilibrates across the cement sheath. In two cases the tangential stress exceeded the tensile strength of the cement sheath. Finally, at long times, the tangential stress was independent of the heat-up rate.

Adjusting the heating rate in a well may not be practical in many well situations; therefore, it would be advantageous if the cement sheath had a temporarily high LCTE during the heat-up phase, but would relax to a lower LCTE as the well temperature reaches equilibrium.

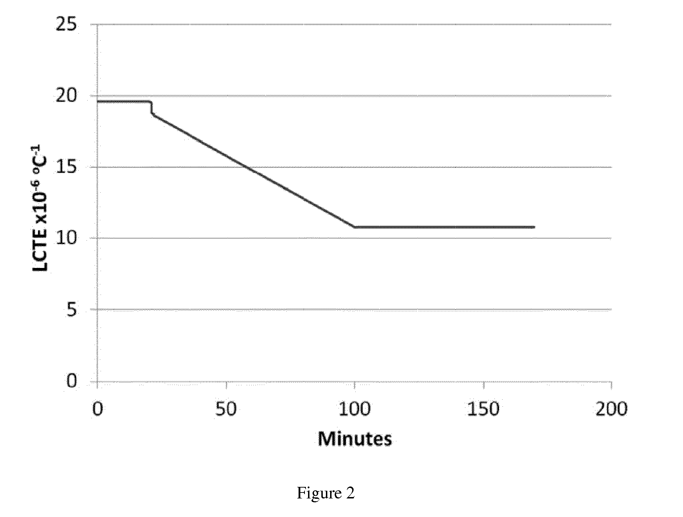

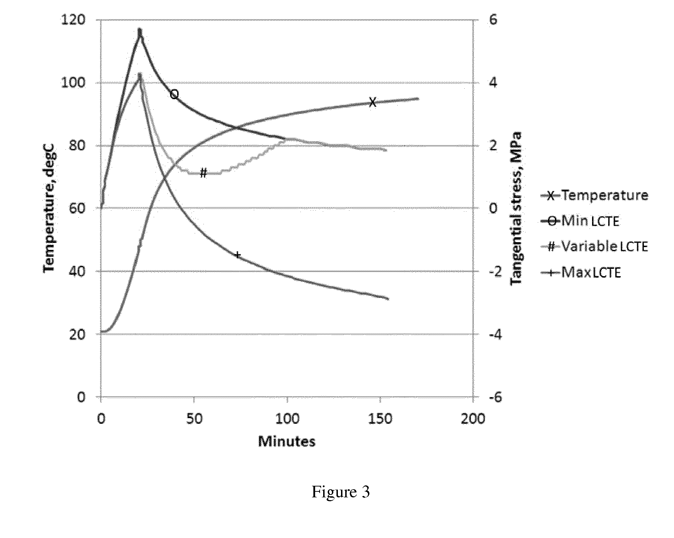

A second CemSTRESS™ simulation evaluated the behavior of three cement sheaths with different LCTEs, at a heat-up rate of 5°C/min. Two of cement sheaths had constant LCTEs, $19.6 \times 10^{-6}/°C$ and $10.8 \times 10^{-6}/°C$. The third cement sheath had a variable LCTE, as shown in Fig. 2. The results of the CemSTRESS™ simulation analyzing these cement sheaths are shown in Fig. 3. The variable LCTE system prevented cement-sheath failure during the rapid temperature increase, and minimized the residual tangential stress at longer times.

The Applicant has determined that cement sheaths with variable LCTEs may be prepared by incorporating certain pozzolans in the cement blend. When the cement sheath is heated, the interstitial water in the cement pores expands. Without wishing to be bound by any theory, if the cement sheath has a low permeability, the heated water cannot escape quickly. As a result, the pore pressure inside the cement sheath increases, thereby increasing the LCTE. Once a constant temperature is reached, the pore pressure slowly dissipates, the cement sheath relaxes and the LCTE decreases to an equilibrium level.

Pozzolans are siliceous materials that react with free calcium hydroxide in set Portland cement, forming additional calcium silicate hydrate and filling pores. The reduced porosity leads to lower permeability. Further details concerning this process are presented in the following publication. Nelson EB, Michaux M and Drochon B: "Cement Additives and Mechanisms of Action, " in Nelson EB and Guillot D (eds.): Well Cementing, 2nd Edition, Houston: Schlumberger (2006) 49-91. Pozzolans that may be effective in the present application comprise blast furnace slag, silica fume and fly ash.

In an aspect, embodiments relate to methods for designing a cement system having a borehole penetrating subterranean formations, at least one casing string and at least one cement sheath. A candidate cement system is selected such that the cement sheath has a known Young's modulus, Poisson's ratio, tensile strength and a variable linear thermal expansion coefficient. The cement system further contains a material that reduces the permeability of the cement sheath. The well and casing geometries are determined. A computer simulator is then used to determine cement-sheath integrity and tangential stress upon the application of heat, pressure or both in the well. If the simulation indicates cement-sheath failure, the candidate cement system is modified such that the variable thermal expansion coefficient is adjusted, and the computer simulator is used again to determine cement-sheath integrity and tangential stress. If the simulation indicates no failure, the candidate cement system is then selected as a final design. The cement may be Portland cement. The material may comprise blast furnace slag, silica fume, fly ash or a combination thereof.

In a further aspect, embodiments relate to methods for cementing a subterranean well having a borehole, at least one casing string and at least one cement sheath. A candidate cement system is selected such that the cement sheath has a known Young's modulus, Poisson's ratio, tensile strength and a variable linear thermal expansion coefficient. The cement is a Portland cement and the cement system further comprises blast furnace slag, silica fume, fly ash or a combination thereof. The well and casing geometries are determined. A computer simulator is then used to determine cement-sheath integrity and tangential stress upon the application of heat, pressure or both in the well. If the simulation indicates cement-sheath failure, the candidate cement system is modified such that the variable thermal expansion coefficient is adjusted, and the computer simulator is used again to determine cement-sheath integrity and tangential stress. If the simulation indicates no failure, the candidate cement system is then selected as a final design. A cement slurry is prepared according to the final design and is then placed in the well. The slurry is allowed to set and then the well is heated to temperatures between about 60°C to about 400°C.

For all aspects, the LCTE of the cement sheath rises to a maximum level during well heating, and then falls as the well temperature equilibrates. The LCTE of the cement system may be higher than or equal that of carbon steel. Furthermore, the tangential stress in the set cement may not exceed the tensile strength of the set cement.

For all aspects, the well may be a thermal-recovery well, a geothermal well or a conventional well whose bottomhole temperature is higher than about 60°C. Those skilled in the art will appreciate that, in the case of thermal-recovery wells, the temperature in question is that to which the well is heated during the injection of steam.

For all aspects, the material concentration in the cement blend may be between about 1% and 50% by weight of cement, or the concentration may be between about 5% and 30% by weight of cement.

For all aspects, the cement system may further comprise set accelerators, set retarders, extenders, weighting materials, gas generating agents, lost circulation materials, fluid-loss additives, antifoam agents or combinations thereof.

If the well temperature exceeds about 110°C, silica may be added to prevent strength retrogression of the cement sheath. Depending on the ultimate temperature, the silica concentration may be adjusted such that the calcium oxide-to-silicon dioxide ($CaO/SiO_2$) ratio is between about 0.6 and 1.2. Such compositions may promote the formation of beneficial calcium-silicate-hydrate minerals such as xonotlite and truscottite. Under these circumstances, the silica concentration in the cement slurry may be between about 20% and 60% by weight of cement, or may be between about 35% and 45% by weight of cement. The particle size of the silica may vary from $0.1\mu m$ to $200\mu m$, preferably from $5\mu m$ to $100\mu m$. If present, other pozzolans such as fly ash and blast furnace slag may also be a source of silica.

## EXAMPLES

The following examples are not limiting and serve to further illustrate the invention.

In the following examples, Applicant employed a method for measuring the LCTE of cement systems that is published in the following publication. Dargaud B and Boukelifa L: "Laboratory Testing, Evaluation, and Analysis of Well Cements, " in Nelson EB and Guillot D (eds.): Well Cementing (2nd Edition) Schlumberger, Houston, USA (2006) 627-658. The method is limited to about 80°C because the apparatus uses water as a heating medium at atmospheric pressure. Heating rates and time at a given temperature may be adjusted as required to simulate different heating conditions in the well. In addition, corrections are made to compensate for the thermal expansion of the test apparatus (LCTE = 1.1 x $10^{-6}$/°C). The cement samples were cylinders 110-150 mm long and 25 mm in diameter.

## EXAMPLE 1

A cement sample was prepared with the following composition: Class G cement plus sufficient water to prepare a slurry with a density of 1890 kg/m$^3$. Prior to the LCTE testing, the sample was cured at 30°C for one week.

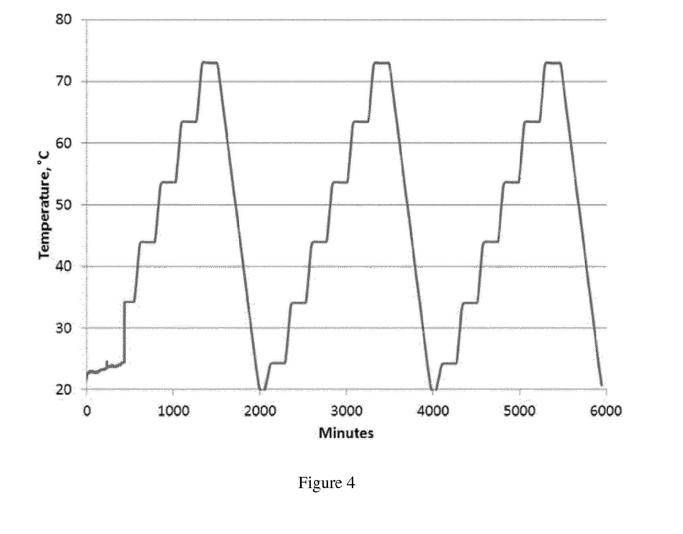

An example temperature profile is shown in Fig. 4. The sample was heated from 20°C to 70°C at a rate of 10°C/hr, stopping every 10°C for three hours to allow equilibrium to be reached. The sample was then cooled from 70°C to 20°C at a rate of 6.25°C/hr. The heating and cooling cycles were repeated three times.

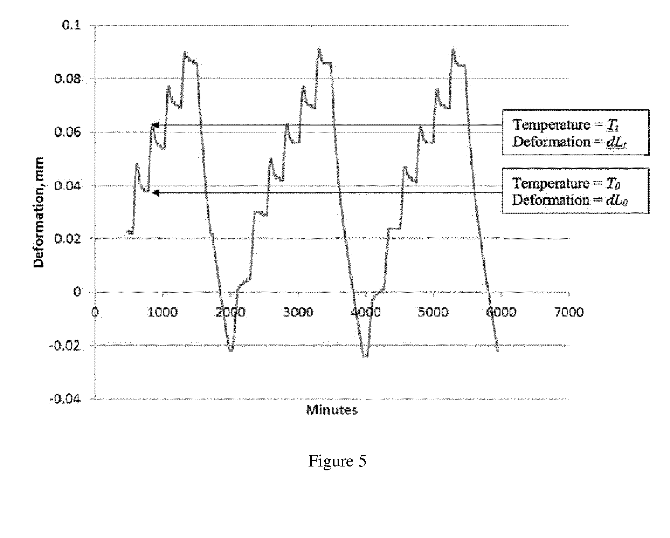

The plot of sample-length change as a function of time and temperature is shown in Fig. 5. There was a significant length change during each heating ramp which then decayed to a lower value during the subsequent isothermal period. For each time period, the LCTE is calculated by determining the change in length from the starting point $dL_0$ at

time 0 to a point $dL_t$ at time $t$. The equation is given below.

$$LCTE(t) = \frac{dL_t - dL_0}{L_0(T_t - T_0)} ,$$

(Eq. 1)

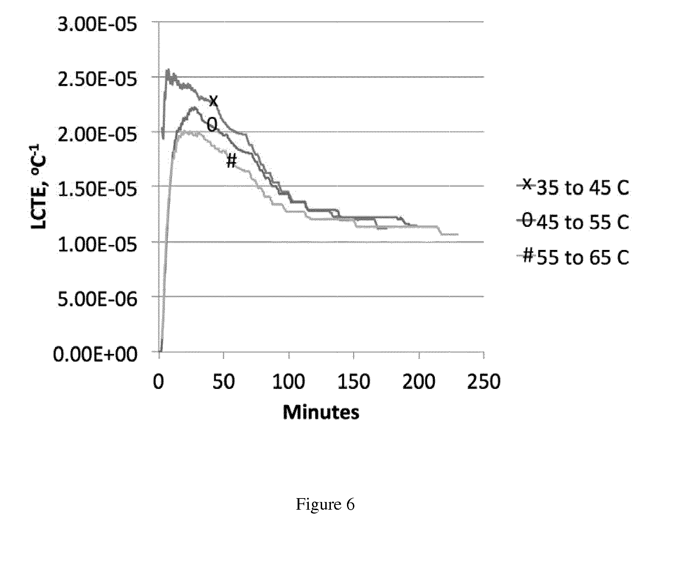

where $LCTE(t)$ is the linear thermal expansion coefficent at time $t$, $T_t$ is the temperature at time $t$ and $T_0$ is the temperature at time 0. LCTEs determined during and after the first temperature ramps from 35°C to 45°C, 45°C to 55°C and 55°C to 65°C are shown in Fig. 6. The LCTE is initially high during the transient stage when the pore pressure has increased, but then decays to a lower value when the pore pressure has dissipated.

**EXAMPLE 2**

A cement sample was prepared with the following composition: Class G cement + 35% silica flour by weight of cement (BWOC). Sufficient water was added to prepare a slurry with a density of 1890 kg/m$^3$. Prior to the LCTE testing, the sample was cured at 85°C for one week.

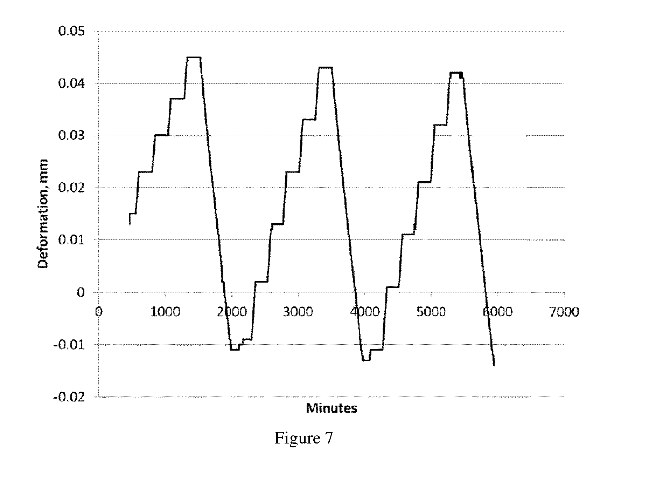

The LCTE measurements were performed using the temperature profile shown in Fig. 4. The deformation of the cement sample during the testing is shown in Fig. 7. The behavior of the cement sample was different from that shown in Fig. 5 (Example 1). There was no transient length change of the sample and subsequent decay. Without wishing to be bound by any theory, there was no pore pressure buildup in this system under the test conditions because the cement sample was more permeable and allowed pore pressure to be relieved during heating.

**EXAMPLE 3**

Two cement systems were prepared as shown in Table 2. The systems were essentially identical except that in System B the Class G cement was replaced by a commercial blended cement (CEM III/A 42,5 N-LH, available from Holcim). This cement is a blend of 59 wt% blast furnace slag, 33 wt% Portland cement, 4.5 wt% gypsum and other minor constituents.

Table 2. Cement compositions.

|  | System A | System B |
|---|---|---|
| Solid Volume Fraction (SVF) | 59% | 59% |
| Class G (BVOB*) | 35% | - |
| Portland cement/blast furnace slag (BVOB) | - | 35% |
| Fine silica (BVOB) | 15% | 15% |
| Silica sand (BVOB) | 50% | 50% |
|  |  |  |
| Silicone antifoam (L/tonne) | 2 | 2 |
| PNS† dispersant (L/tonne) | 4 | 4 |
| Polymer based antisettling agent (BWOB**) | 0.2% | 0.2% |
| AMPS^ based fluid-loss additive (BWOB) | 0.07% | 0.07% |
| *BVOB = by volume of blend; **BWOB = by weight of blend; † = PNS = polynaphthalene sulfonate; ^AMPS = 2-acrylamido-2-methylpropane sulfonic acid | | |

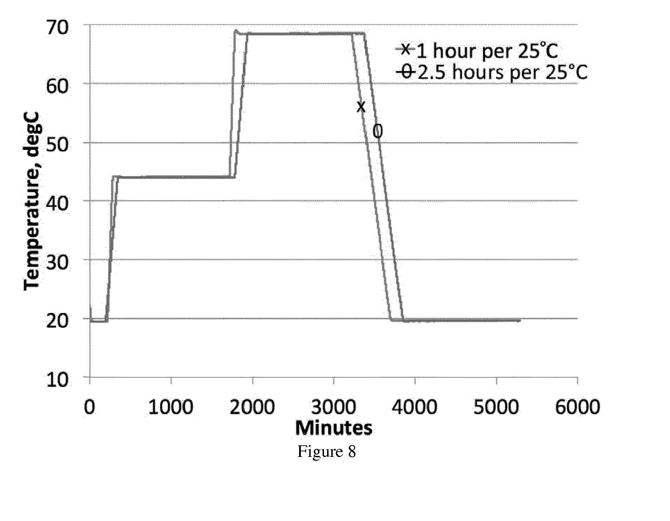

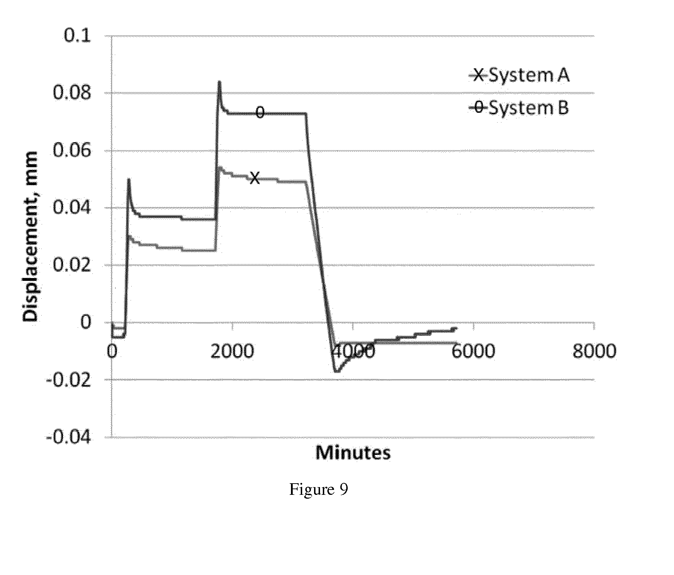

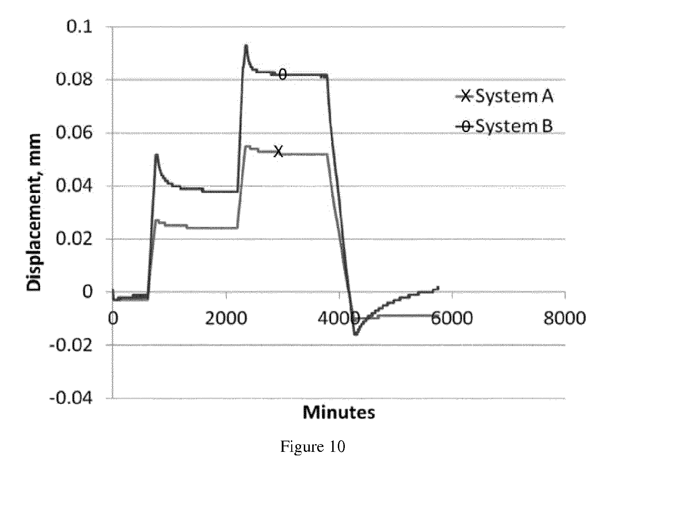

The slurries were cured for one week at 20.7 MPa pressure and 85°C before the thermal expansion measurements were performed. Samples of each system were exposed to two different temperature ramps: 25°C in 1.0 hour and 25°C in 2.5 hours (Fig. 8). The thermal expansion results are shown in Fig. 9 (25°C/1 hr) and Fig. 10 (25°C/2.5 hr).

Two principal points may be deduced from the results. Firstly, System B had a variable LCTE, as evidenced by the displacement peaks at the ends of the heat-up periods, followed by significant sample-length reductions during the isothermal periods. This behavior is independent of the heating rate. Secondly, even when equilibrium is reached, the LCTE of System B (12 x $10^{-6}$/°C) was higher than that of System A (8 x $10^{-6}$/°C).

**EXAMPLE 4**

A series of cement systems was prepared. The compositions, presented in Table 3, were all prepared with Class G cement.

Table 3. Cement compositions.

| | High SVF | BFS | Silica Fume | MK- | MK+ | FA1 | FA2 |
|---|---|---|---|---|---|---|---|
| Solid Volume Fraction (SVF) (%) | 50.4 | 44.7 | 44.8 | 42 | 42 | 44.7 | 44.8 |
| Silica Flour (% BWOC) | 35 | 49 | 17.4 | 35 | 25.5 | 49 | 17.4 |
| Blast Furnace Slag (BFS) (% BWOC) | - | 36.5 | - | - | - | - | - |
| Silica Fume (% BWOC) | - | - | 14.4 | - | - | - | - |
| Metakaolin (MK) (% BWOC) | - | - | - | 9.6 | 19 | - | - |
| Fly Ash (FA) (% BWOC) | - | - | - | - | - | 29.7 | 15.7 |
| | | | | | | | |
| Silicone Antifoam Agent (L/tonne) | 2.7 | 2.7 | 2.7 | 3.9 | 3.9 | 2.7 | 2.7 |
| Acrylic Polymer Dispersant (L/tonne) | - | 7.7 | 5.5 | 5.9 | 5.9 | 7.7 | 5.5 |
| Calcium Chloride (% BWOC) | - | 2 | 2 | 2 | 2 | 2 | 2 |
| PNS Dispersant (L/tonne) | 6.7 | - | - | - | - | - | - |
| Biopolymer Antisettling Agent (% BWOC) | 0.2 | - | - | - | - | - | - |

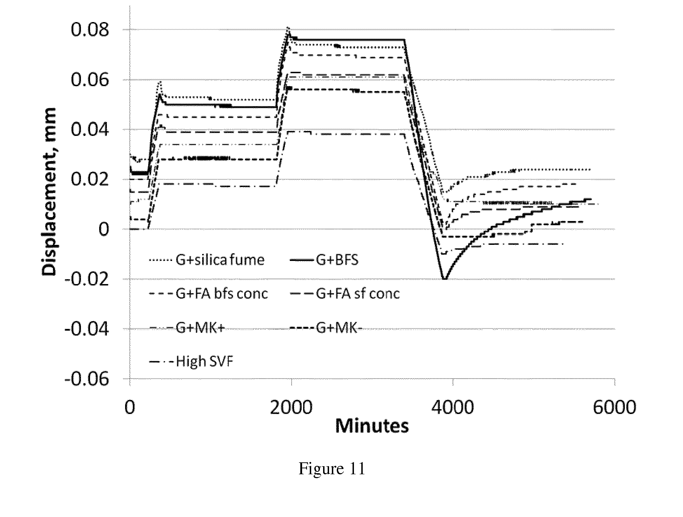

The samples were prepared by the same method described in Example 3. The cement samples were then exposed to two heat-up and isothermal cycles. During the first cycle, the samples were heated from 20° to 44°C; during the second cycle, the samples were heated from 44°C to 68°C. The results, shown in Fig. 11, indicated that the only systems to demonstrate a variable LCTE, evidenced by a temporary displacement peak at the end of each heat-up period, were those containing silica fume, blast furnace slag or fly ash.

Although various embodiments have been described with respect to enabling disclosures, it is to be understood that the preceding information is not limited to the disclosed embodiments. Variations and modifications that would occur to one of skill in the art upon reading the specification are also within the scope of the disclosure, which is defined in the appended claims.

**Claims**

1. A method for designing a cement system for placement in a well having a borehole penetrating subterranean formations, at least one casing string and at least one cement sheath, comprising:

    (i) selecting a candidate cement system such that the cement sheath has a known Young's modulus, Poisson's ratio, tensile strength and a variable linear thermal expansion coefficient;
    (ii) determining the well geometry and casing geometry;
    (iii) using a computer simulator to determine cement-sheath integrity and tangential stress upon application of heat, pressure or both in the well;
    (iv) if the simulation indicates cement-sheath failure, modifying the candidate cement system to adjust the variable thermal expansion coefficient, and repeating step iii.; and
    (v) if no failure is indicated, selecting the candidate cement system as a final design.

2. The method of claim 1, wherein the cement is Portland cement and further comprises material that reduces the permeability of the cement sheath, the material comprising blast furnace slag, silica fume, fly ash or a combination thereof.

3. The method of claim 1 or 2, wherein the thermal expansion coefficient of the cement sheath rises to a maximum level during well heating, then falls as the well temperature equilibrates.

4. The method of any one of claims 1-3, wherein the thermal expansion coefficient of the cement system is higher than or equal to that of carbon steel.

5. The method of any one of claims 1-4, wherein the well is a thermal recovery well, a geothermal well or a conventional well whose bottomhole temperature is higher than about 60°C.

6. The method of any one of claims 1-5, wherein the material concentration is between about 1% and 50% by weight of solid cement-system blend.

7. The method of any one of claims 1-6, wherein the tangential stress in the set cement does not exceed the tensile strength of the set cement.

8. The method of any one of claims 1-7, wherein the cement system further comprises set accelerators, set retarders, extenders, weighting materials, lost circulation materials, fluid-loss additives, antifoam agents or combinations thereof.

9. A method for cementing a subterranean well having a borehole, at least one casing string and at least one cement sheath, comprising:

(i) selecting a candidate cement system such that the cement sheath has a known Young's modulus, Poisson's ratio, tensile strength and a variable linear thermal expansion coefficient, wherein the cement is Portland cement and the system further comprises a material comprising blast furnace slag, silica fume, fly ash or a combination thereof;
(ii) determining the well geometry and casing geometry;
(iii) using a computer simulator to determine cement-sheath integrity and tangential stress upon application of heat, pressure or both in the well;
(iv) if the simulation indicates cement-sheath failure, modifying the candidate cement system to adjust the variable thermal expansion coefficient, and repeating step iii.;
(v) if no failure is indicated, selecting the candidate cement system as a final design.
(vi) preparing a cement slurry according to the final design;
(vii) placing the slurry into the well;
(viii) allowing the slurry to set; and
(ix) heating the well.

10. The method of claim 9, wherein the thermal expansion coefficient of the cement sheath rises to a maximum level during well heating, then falls as the well temperature equilibrates.

11. The method of claim 9 or 10, wherein the coefficient of thermal expansion of the cement system is higher than or equal to that of carbon steel.

12. The method of any one of claims 9-11, wherein the well is a thermal recovery well, a geothermal well or a conventional well whose bottomhole temperature is higher than about 60°C.

13. The method of any one of claims 9-12, wherein the material concentration is between about 1% and 50% by weight of solid cement-system blend.

14. The method of any one of claims 9-13, wherein the tangential stress in the set cement does not exceed the tensile strength of the set cement.

15. The method of any one of claims 9-14, wherein the well is heated to temperatures between about 85°C to about 400°C.

Figure 1

Figure 2

Figure 3

Figure 4

Figure 5

Figure 6

Figure 7

Figure 8

Figure 9

Figure 10

Figure 11

Europäisches
Patentamt

European
Patent Office

Office européen
des brevets

**EUROPEAN SEARCH REPORT**

Application Number

EP 12 30 6603

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/018154 A1 (JAMES SIMON G [FR]) 26 January 2012 (2012-01-26) | 1,5,7 | INV. E21B33/14 |
| Y | * paragraph [0040] - paragraph [0046]; figure 1 * | 2,4,6,8, 9,11-15 | C09K8/467 E21B43/24 |
| Y | WO 2012/022364 A1 (SCHLUMBERGER SERVICES PETROL [FR]; SCHLUMBERGER TECHNOLOGY BV [NL]; SC) 23 February 2012 (2012-02-23) * paragraph [0028] - paragraph [0031]; claims 1,2,4,7,8, * | 2,4,6,8, 9,11-15 | |
| X | US 2012/145392 A1 (JAMES SIMON G [FR]) 14 June 2012 (2012-06-14) * paragraph [0035] * * paragraph [0009] - paragraph [0012]; figures 3,4 * * paragraph [0021] - paragraph [0029] * | 1,4-8 | |

|  |
|---|
| TECHNICAL FIELDS SEARCHED (IPC) |
| E21B C09K |

The present search report has been drawn up for all claims

| Place of search | Date of completion of the search | Examiner |
|---|---|---|
| The Hague | 15 May 2013 | Dantinne, Patrick |

EPO FORM 1503 03.82 (P04C01)

## ANNEX TO THE EUROPEAN SEARCH REPORT
## ON EUROPEAN PATENT APPLICATION NO.

EP 12 30 6603

This annex lists the patent family members relating to the patent documents cited in the above-mentioned European search report.
The members are as contained in the European Patent Office EDP file on
The European Patent Office is in no way liable for these particulars which are merely given for the purpose of information.

15-05-2013

| Patent document cited in search report | Publication date | Patent family member(s) | | Publication date |
|---|---|---|---|---|
| US 2012018154 A1 | 26-01-2012 | NONE | | |
| WO 2012022364 A1 | 23-02-2012 | AU | 2010359200 A1 | 04-04-2013 |
| | | CA | 2808203 A1 | 23-02-2012 |
| | | WO | 2012022364 A1 | 23-02-2012 |
| US 2012145392 A1 | 14-06-2012 | CA | 2758514 A1 | 08-06-2012 |
| | | US | 2012145392 A1 | 14-06-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **THIERCELIN MJ et al.** Cement Design Based on Cement Mechanical Response,. *paper SPE 52890,* 1998
- Cement Additives and Mechanisms of Action. **NELSON EB ; MICHAUX M ; DROCHON B.** Well Cementing. 2006, 49-91
- Laboratory Testing, Evaluation, and Analysis of Well Cements. **DARGAUD B ; BOUKELIFA L.** Well Cementing. 2006, 627-658